Europäisches Patentamt

European Patent Office

Office européen des brevets

(11) Publication number: **0 197 452 B1**

# EUROPEAN PATENT SPECIFICATION

(45) Date of publication of patent specification: **13.05.92** (51) Int. Cl.5: **C30B 25/18**

(21) Application number: **86104239.8**

(22) Date of filing: **27.03.86**

(54) Method for producing high quality epitaxial layers by molecular beam epitaxy.

(30) Priority: **10.04.85 US 721537**

(43) Date of publication of application:
**15.10.86 Bulletin 86/42**

(45) Publication of the grant of the patent:
**13.05.92 Bulletin 92/20**

(84) Designated Contracting States:
**DE FR GB IT NL**

(56) References cited:
**US-A- 4 419 178**

**JOURNAL OF APPLIED PHYSICS, vol. 54, no. 12, December 1983, pages 6982-6988, American Institute of Physics, New York, US; M.HEIBLUM et al.: "Growth by molecular beam epitaxy and characterization of high purity GaAs and AlGaAs"**

**JOURNAL OF CRYSTAL GROWTH, vol. 61, no. 3, May 1983, pages 449-457, North-Holland Publishing Company, Amsterdam, NL; D.H.REEP et al.: "Morphology of organometallic CVD grown GaAs epitaxial layers"**

(73) Proprietor: **MOTOROLA, INC.**
**1303 East Algonquin Road**
**Schaumburg, IL 60196(US)**

(72) Inventor: **Curless, Jay A.**
**7110 E. Continental, 125**
**Scottsdale Arizona 85257(US)**
Inventor: **Kramer, Gary D.**
**6022 E. Windsor**
**Scottsdale Arizona 85257(US)**
Inventor: **Tsui, Raymond K.**
**7911 E. San Miguel 8**
**Scottsdale Arizona 85253(US)**
Inventor: **Peffley, Marilyn S.**
**1320 E. Highland Avenue, 54**
**Phoenix Arizona 85014(US)**
Inventor: **Rode, Daniel L.**
**Nine Prado**
**St. Louis Missouri 63124(US)**

(74) Representative: **Ibbotson, Harold et al**
**Motorola Ltd Patent and Licensing Operations - Europe Jays Close Viables Industrial Estate**
**Basingstoke Hampshire RG22 4PD(GB)**

EP 0 197 452 B1

**Description**

Field of the Invention

The present invention relates, in general, to a method for producing high quality epitaxial layers of group III-V, group II-VI and group IV compositions by means of molecular beam epitaxy (MBE). More particularly, the invention relates to a method of producing such epitaxial layers having smooth surface morphologies using MBE techniques under growth conditions which normally produce rough-surfaced growth.

Background of the Invention

The production of high quality epitaxial layers of group III-V compositions, such as GaAs, AlGaAs, and InP, is extremely important to the realization of improved high speed, optical and other semiconductor devices. Other compositions, such as group II-VI and group IV compounds, are similarly important. While liquid phase epitaxy (LPE) has been the dominant process used to produce such layers, MBE has recently become more widely used.

It has been noted that when MBE is used to produce layers such as $Al_xGa_{1-x}As$ under certain growth conditions, the resulting surface is not smooth. This is particularly troublesome when another layer is to be grown over the rough surface, such as when fabricating double heterostructure optical devices and high-speed transistors. Various performance degradations have been attributed to the rough surface morphology of the $Al_xGa_{1-x}As$ layer.

Alterations in the MBE growth conditions have been suggested to alleviate the rough surface phenomenon. These include raising the substrate temperature, drastically reducing the growth rate and/or controlling the V/III flux ratio. However, in some situations it is desirable to grow $Al_xGa_{1-x}As$ or other III-V layers under conditions which normally would produce rough surface morphologies. For instance, it may be desirable to grow such materials at commercially viable growth rates or at particular substrate temperatures. To date, there has been no method available to produce smooth-surfaced layers without altering the MBE growth conditions.

Summary of the Invention

Accordingly, it is an object of the present invention to provide a method of producing smooth surfaced epitaxial layers by MBE under growth conditions which would normally produce rough-surfaced layers.

In accordance with the present invention there is provided a method of growing a substantially smooth surfaced epitaxial layer of monocrystalline material comprising the steps of:

providing a monocrystalline gallium arsenide substrate having a growth surface oriented away from a ⟨100⟩ axis of said substrate toward a ⟨111⟩ gallium axis by between 2.75° and 10°; and

exposing said substrate to molecular beam epitaxial growth conditions which normally would produce rough-surfaced growth on a nominally ⟨100⟩ substrate.

This and other objects and advantages of the present invention will be apparent to one skilled in the art from the detailed description below taken together with the drawings.

Brief Description of the Drawings

FIGs. 1A - 1D are phase contrast photomicrographs of the surfaces of $Al_xGa_{1-x}As$ layers grown by MBE;

FIG. 2 is a graph illustrating the improvement in the layer's optical quality realized through the present invention;

FIG.s 3A and 3B are photomicrographs in cross-section of $Al_xGa_{1-x}As$ epitaxial layers illustrating an improvement in morphology; and

FIG.s 4A and 4B are graphs illustrating surface profiles of a prior art layer and a layer according to the present invention, respectively.

Detailed Description of the Invention

In the particular embodiment of the present invention described herein, a three chamber Varian GEN II MBE system was used to grow epitaxial layers of $Al_xGa_{1-x}As$ on GaAs substrates. In addition to the standard ion and titanium sublimation pumps, a closed-loop helium cryopump was connected to the growth chamber.

The cleaning process applied to each substrate prior to loading into the MBE system comprised sequential rinsing in toluene, acetone, isopropyl alcohol and D.I. water; followed by etching in a 5:1:1 solution of $H_2SO_4:H_2O_2:H_2O$; followed by a rinse in D.I. water and blow drying in dry nitrogen. The substrates were then mounted onto the molybdenum mounting blocks using molten indium. In addition, each substrate was out-gassed at a temperature of approximately 450° C for approximately 30 minutes in the analysis/preparation chamber of the system prior to loading into the growth chamber.

Reproducibly measuring temperatures in MBE systems is particularly difficult. In the particular embodiment of the present invention these difficulties were overcome as follows. Direct measurements were obtained by means of a thermocouple which was placed in contact with the backside of the mounting block. In addition, a dual wavelength infrared pyrometer was used to observe the temperature of the substrate surfaces on the front surface of the mounting block. Finally, Reflected High-Energy Electron Diffraction (RHEED) patterns were observed and used in conjunction with the GaAs congruent sublimation temperature of 640° C to calibrate the other temperature readings.

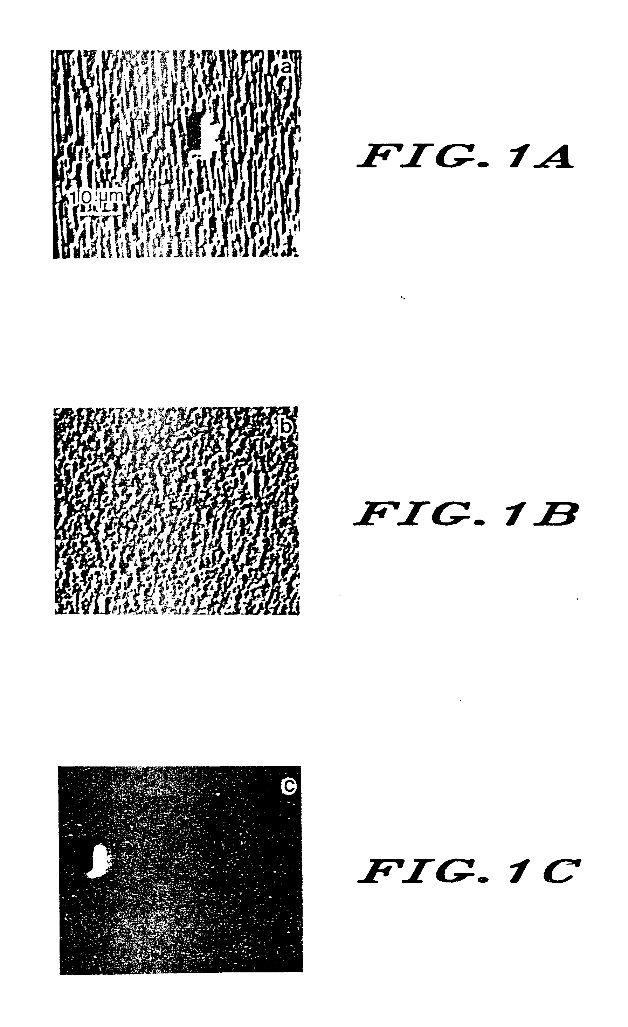

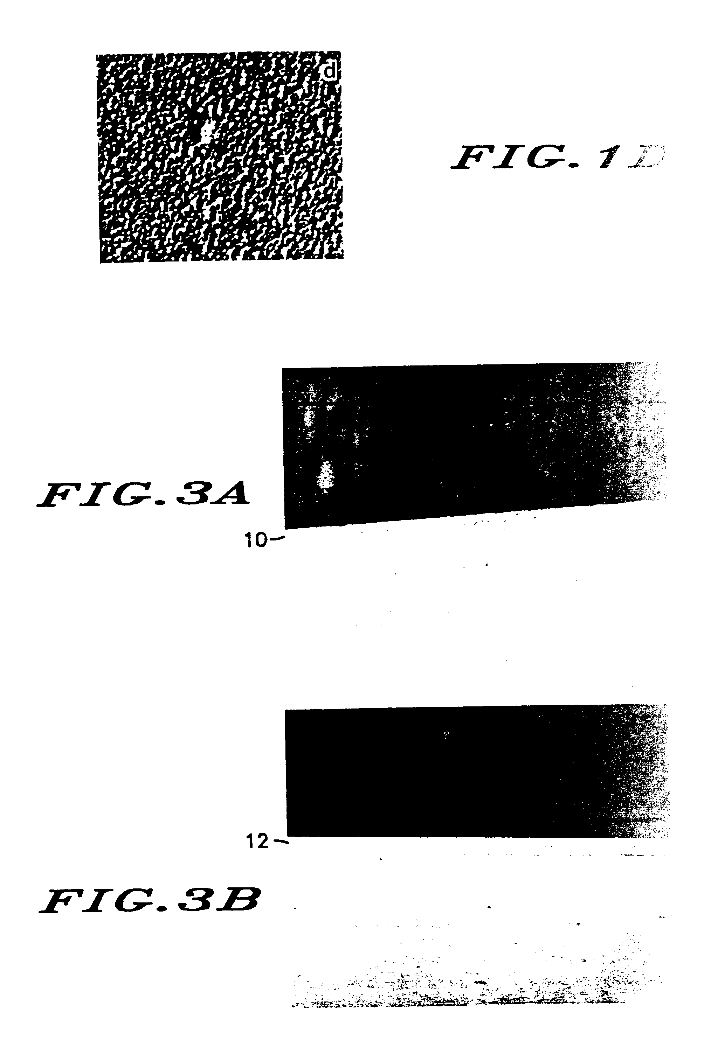

Referring now to FIGs. 1A - 1D, the growth of $Al_xGa_{1-x}As$ according to the principles of the present invention is described. FIGs. 1A - 1D are phase contrast photomicrographs illustrating the surface morphologies of four $Al_xGa_{1-x}As$ layers grown by MBE on four different substrates (A,B,C,and D). The four samples illustrate the effect of mis-orienting the growth surface of the substrate by various amounts away from the normal orientation in a critical direction.

The convention used in describing the orientation of a surface of a crystal substrate involves the relationship of a line perpendicular to the surface of the substrate to the axes of the substrate crystal. The axes of the crystal are defined with respect to the unit cell which specifies the atomic structure of the crystal.

Sample A (FIG. 1A) serves as a control and is nominally a ⟨100⟩ substrate, as is commonly used. In fact, the orientation of this substrate was determined by X-ray diffraction to be 0° 7' away from ⟨100⟩ toward a ⟨111⟩A, or ⟨111⟩gallium, axis. The orientation of sample B is 2° 33' away from the ⟨100⟩ toward a ⟨111⟩B axis. The orientation of sample C is 2° 45' away from the ⟨100⟩ toward a ⟨111⟩A axis. The orientation of sample D is 3° 6' away from the ⟨100⟩ axis toward a ⟨111⟩B axis. These substrates were obtained by conventional crystal cutting techniques and the orientations were each verified by X-ray diffraction.

These four samples were grown simultaneously, so as to avoid any differences in growth conditions. They were mounted with indium on a single mounting block, which was rotated during growth. Substrate temperatures were maintained at 675° C, which is a condition which normally produces rough-surfaced growth on nominally ⟨100⟩ substrates. The beam equivalent pressures (BEP), as determined by a nude ion guage rotated into the growth position, were 6.7 x $10^{-7}$ torr for Ga and 7.0 x $10^{-8}$ torr for Al. The $As_4$ BEP was 11.4 x $10^{-6}$ torr. No intentional doping was carried out. The resulting growth rate is approximately 1 micron/hour. The layer produced is p-type $Al_{0.15}Ga_{0.85}As$ with a background free carrier concentration of 1 x $10^{16}$ /$cm^3$ at room temperature. The $Al_xGa_{1-x}As$ layer on each substrate is approximately 4 microns thick.

The growth conditions described normally produce rough surface morphology, as is evidenced in FIG. 1A. This surface morphology has been previously reported and has been cited as the cause of a number of performance degradations of devices constructed with such layers.

Samples B and D (FIG.s 1B and 1D, respectively) also show surface roughness. It is apparent that a mis-orientation toward the ⟨111⟩B axis is not effective to produce smooth-surfaced growth.

The phase contrast micrograph of sample C, however, shows a surface substantially free of the rough morphology of the other samples. The only defect apparent in illustrated portion of sample C is an oval defect of the type which has been reported elsewhere and which is thought to be unrelated to rough surface morphology.

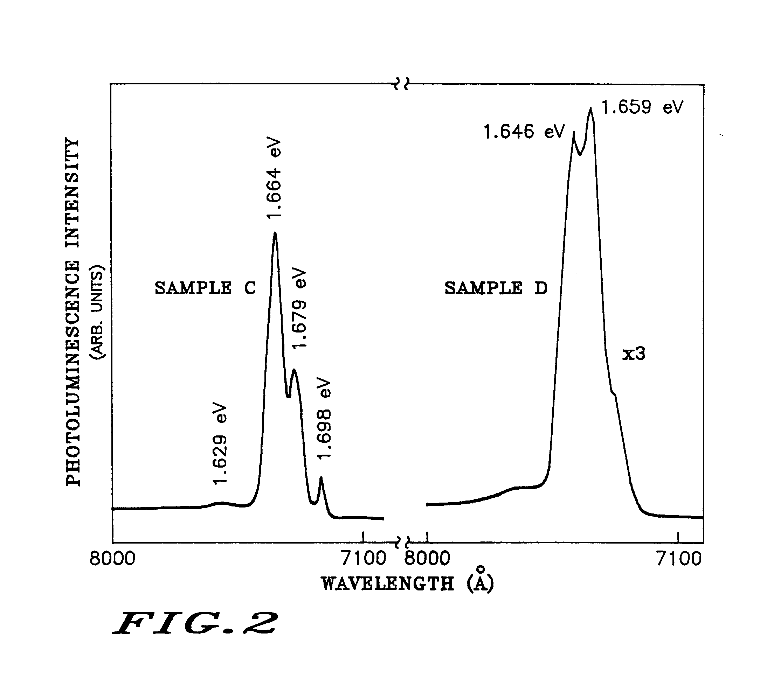

As is apparent from FIG. 1C, it is possible to produce smooth-surfaced layers of $Al_xGa_{1-x}As$ by MBE under conditions which would normally produce rough-surfaced layers by mis-orienting the growth surface of the substrate in a critical direction. FIG. 2 demonstrates that such a layer also exhibits an improved photoluminescence (PL) spectrum. The graph of FIG. 2 illustrates the PL spectra (at 4.2 K) of samples C and D. The spectra were obtained using the 5145 angstrom line of an argon ion laser as the excitation source. The intensity of the spectrum for sample D is expanded by a factor of three with respect to that of sample C.

The peak in the spectrum of sample C which is labelled 1.698 eV is thought to result from the recombination of a bound exciton. This peak has a full width at half maximum of approximately 5 meV. This peak is thought to be indicative of relatively high quality material. A higher substrate temperature and/or a lower V/III flux ratio might have produced better results. The peak at 1.679 eV is thought to be related to a free-to-bound transition involving carbon acceptors. The peak at 1.664 eV is also thought to be acceptor-related, with the acceptor possibly being silicon. A phonon replica of this peak is seen at 1.629 eV.

The spectrum of sample D shows a substantially lower quantity of bound exciton recombination than that of sample C. Indeed, no peak corresponding to an excitonic transition is apparent. The peak at 1.659 eV and its shoulder on the high energy side are believed to be related to impurities. The peak at 1.646 eV is believed to be defect-related. This spectrum is typical of those of all rough-surfaced samples.

A comparison of the PL spectra of FIG. 2 demonstrates that the defect-related peak at 1.646 eV in sample D, which is typical of prior art layers, is greatly reduced in intensity in the critically mis-oriented sample C. In fact, the spectrum of sample C shows no evidence of a defect-related peak at the scale of FIG. 2. In addition, the bound exciton peak at 1.698 eV in the spectrum of sample C is thought to be evidence of improved material quality. This peak is apparently absent in the spectrum of sample D.

The rough surface morphology of $Al_xGa_{1-x}As$ layers grown by MBE on normally oriented substrates is believed to be related to the long range interaction between monatomic steps on the substrate surface. It is believed that the terraces, hillocks and other surface features are related to the reaction of the growing material to uneven surface energy caused by these steps. The bunching of material into hillocks, terraces and other features is thought to decrease the overall surface energy.

The mis-orientation required to alleviate this problem is most likely to be specific to the particular growth conditions. To investigate this possibility, a number of $Al_xGa_{1-x}As$ layers were grown under different conditions and on differently oriented substrates. The results of this work are summarized below.

A number of samples of $Al_xGa_{1-x}As$ were grown on GaAs substrates mis-oriented from the ⟨100⟩ toward the nearest ⟨111⟩B axis by varying amounts. The substrate temperature was 675° C and the Al fraction (x) was 0.15. These samples exhibited uniformly rough surface morphology and relatively poor photoluminescence spectra.

Table I, below, summarizes the results of a number of sample runs carried out at a substrate temperature of 620° C. In each case, $Al_x$-$Ga_{1-x}As$ (x = 0.30) was grown on a GaAs substrate mis-oriented from the ⟨100⟩ toward the nearest ⟨111⟩A axis by the specified amount. Table I illustrates the dependence of the critical angle of mis-orientation on the various growth parameters.

TABLE I

| SAMPLE RUN | BEP As (torr) | BEP Ga (torr) | BEP Al (torr) | MIS-ORIENT. | MORPHOLOGY |
|---|---|---|---|---|---|
| 175 | $5.4 \times 10^{-6}$ | $4.6 \times 10^{-7}$ | $1.1 \times 10^{-7}$ | 0° | ROUGH |
| | | | | 3° | ROUGH |
| | | | | 5° | SMOOTH |
| 174 | $4.7 \times 10^{-6}$ | $4.8 \times 10^{-7}$ | $1.0 \times 10^{-7}$ | 0° | ROUGH |
| | | | | 2.5° | ROUGH |
| | | | | 2.75° | ROUGH |
| | | | | 3° | ROUGH |
| 185 | $3.5 \times 10^{-6}$ | $4.7 \times 10^{-7}$ | $1.3 \times 10^{-7}$ | 0° | ROUGH |
| | | | | 3° | SMOOTH |
| | | | | 3.5° | SMOOTH |
| | | | | 7° | SMOOTH |
| 188 | $3.5 \times 10^{-6}$ | $4.6 \times 10^{-7}$ | $1.2 \times 10^{-7}$ | 0° | ROUGH |
| | | | | 4° | SMOOTH |
| | | | | 7° | SMOOTH |
| | | | | 10° | SMOOTH |
| 191 | $3.3 \times 10^{-6}$ | $4.8 \times 10^{-7}$ | $1.2 \times 10^{-7}$ | 0° | ROUGH |
| | | | | 4° | SMOOTH |
| | | | | 5° | SMOOTH |
| | | | | 7° | SMOOTH |
| 179 | $2.4 \times 10^{-6}$ | $5.0 \times 10^{-7}$ | $1.0 \times 10^{-7}$ | 0° | ROUGH |
| | | | | 3° | MIXED |
| | | | | 5° | SMOOTH |

4

Table II, below, summarizes the results of a number of samples grown at a substrate temperature of 650° C. Other than the temperature and the several BEP's which are shown, the conditions were identical to those of the 620° C samples.

TABLE II

| SAMPLE RUN | BEP As (torr) | BEP Ga (torr) | BEP Al (torr) | MIS-ORIENT. | MORPHOLOGY |
|---|---|---|---|---|---|
| 177 | $7.3 \times 10^{-6}$ | $5.0 \times 10^{-7}$ | $1.1 \times 10^{-7}$ | 0°<br>3°<br>5° | ROUGH<br>MIXED<br>SMOOTH |
| 178 | $4.8 \times 10^{-6}$ | $4.9 \times 10^{-7}$ | $1.1 \times 10^{-7}$ | 0°<br>3°<br>5° | ROUGH<br>MIXED<br>SMOOTH |

Finally, TABLE III, below, summarizes the results of a number of sample runs at a substrate temperature of 675° C. In these runs, the Al fraction was 0.15. The other conditions were unchanged.

TABLE III

| SAMPLE RUN | BEP As (torr) | BEP Ga (torr) | BEP Al (torr) | MIS-ORIENT. | MORPHOLOGY |
|---|---|---|---|---|---|
| 153 | $1.1 \times 10^{-7}$ | $6.7 \times 10^{-7}$ | $7.0 \times 10^{-8}$ | 0°<br>2.75° | ROUGH<br>SMOOTH |
| 176 | $9.2 \times 10^{-6}$ | $4.9 \times 10^{-7}$ | $4.7 \times 10^{-8}$ | 0°<br>3°<br>5° | ROUGH<br>SMOOTH<br>SMOOTH |

Photoluminescence spectra obtained for some of the samples described above confirm the conclusion that the smooth surface morphology generally indicates a higher quality layer.

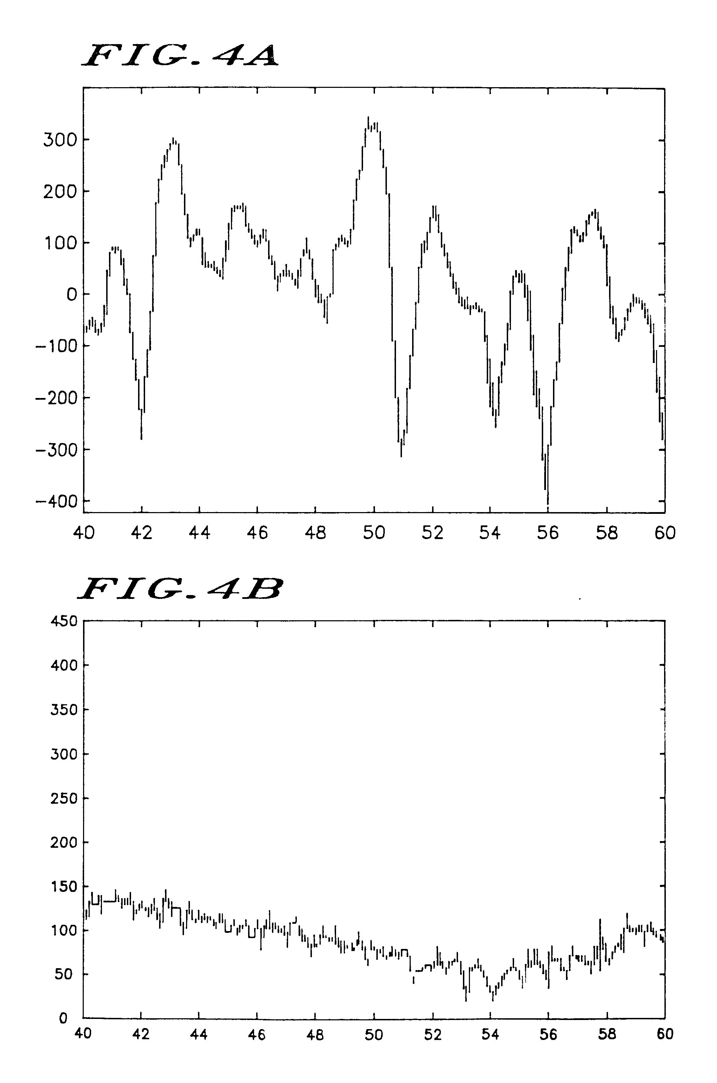

FIG.s 3A and 3B are photomicrographs in cross-section illustrating the improvement in layer quality obtained by correctly mis-orienting the substrate. FIG. 3A is a cross-section at approximately 1000X of the layer grown on the nominally <100> substrate in sample run 178 (see TABLE II). As is apparent, epitaxial layer 10 has a number of morphological defects visible at this magnification. FIG. 3B is a similar cross-sectional view of epitaxial layer 12 which was grown on the substrate oriented 5° from the ⟨100⟩ toward a ⟨111⟩A axis in sample run 178. As is apparent, the improved surface morphology apparent in FIG. 1C corresponds to an improved structure throughout the layer. This implies that mis-orienting the substrate in the proper direction may improve the homogeneity of dopants introduced during layer growth.

FIG.s 4A and 4B illustrate the improvement in surface morphology realized by the use of the present invention. Both are graphs representing the output of an instrument (a Sloan DEKTAK II profilometer) which scans the surface of a body and produces a representation of the surface profile thereof. In both FIG.s, the horizontal axis represents distance over the surface of the body in microns and the vertical axis represents the relative height of the surface in angstroms.

FIG. 4A is the surface profile of a portion of the epitaxial layer grown on a nominally ⟨100⟩ substrate in sample run 153 (see TABLE III). The surface varies in relative height by more than 500 angstroms over distances of less than 10 microns.

FIG. 4B is the surface profile of the layer grown on a substrate oriented 2.75° away from the ⟨100⟩ toward a ⟨111⟩A axis. The vertical axis of this graph is expanded by approximately a factor of two with respect to that of FIG. 4A. This surface varies by less than approximately 100 angstroms over a distance of more than 10 microns. Obviously, if one desires to produce an epitaxial layer 10 only a few hundred angstroms in total thickness, the layer of FIG. 4A is unacceptable. On the other hand, the layer grown on a critically mis-oriented substrate has sufficient surface smoothness to be useful in such an application.

A method of producing high quality epitaxial layers by MBE growth has been described. The method allows the production of smooth-surfaced layers under growth conditions which normally produce rough-surfaced growth. Various modifications and changes will be apparent to one skilled in the art.

EP 0 197 452 B1

**Claims**

1. A method of growing a substantially smooth surfaced epitaxial layer of monocrystalline material comprising the steps of:

   providing a monocrystalline gallium arsenide substrate having a growth surface oriented away from a ⟨100⟩ axis of said substrate toward a ⟨111⟩ gallium axis by between 2.75° and 10°; and

   exposing said substrate to molecular beam epitaxial growth conditions which normally would produce rough-surfaced growth on a nominally ⟨100⟩ substrate.

2. A method according to claim 1 wherein said step of exposing said substrate further comprises the steps of:

   bringing said substrate to a temperature between 600°C and 700°C; and

   exposing said substrate to a molecular beam flux of Al, Ga and As.

3. A method according to claim 2 wherein said epitaxial layer is $Al_{.15}Ga_{.85}As$ and said substrate is oriented away from said ⟨100⟩ axis by at least 2.75° and said substrate is maintained at a temperature of approximately 675°C.

4. A method according to claim 2 wherein said epitaxial layer is $Al_{.30}Ga_{.70}As$ and said substrate is oriented away from said ⟨100⟩ axis by at least 5° and said substrate is maintained at a temperature of approximately 650°C.

5. A method according to claim 2 wherein said epitaxial layer is $Al_{.30}Ga_{.70}As$ and said substrate is oriented away from said ⟨100⟩ axis by at least 3° and said substrate is maintained at a temperature of approximately 620°C.

**Revendications**

1. Une méthode de croissance d'une couche épitaxiale à surface substantiellement lisse d'un matériau monocristallin comprenant les étapes suivantes :

   on fournit un substrat d'arséniure de gallium monocristallin ayant une surface de croissance orientée en s'écartant d'un axe ⟨100⟩ dudit substrat dans la direction d'un axe du gallium ⟨111⟩ d'une valeur comprise entre 2,75° et 10° ; et

   on expose ledit substrat à des conditions de croissance épitaxiale par faisceaux moléculaires qui produiraient normalement une croissance à surface rugueuse sur un substrat d'axe ⟨100⟩ nominalement.

2. Une méthode selon la revendication 1, selon laquelle ladite étape d'exposition dudit substrat comprend en outre les étapes suivantes :

   on porte ce substrat à une température comprise entre 600°C et 700°C ; et

   on expose ledit substrat à un flux de faisceau moléculaire de Al, Ga et As.

3. Une méthode selon la revendication 2, selon laquelle ladite couche épitaxiale est du $Al_{0,15}Ga_{0,85}As$ et ledit substrat est orienté en s'écartant dudit axe ⟨100⟩ d'au moins 2,75° et ledit substrat est maintenu à une température approximativement de 675°C.

4. Une méthode selon la revendication 2, selon laquelle ladite couche épitaxiale est du $Al_{0,03}Ga_{0,07}As$ et ledit substrat est orienté en s'écartant dudit axe ⟨100⟩ d'au moins 5° et ledit substrat est maintenu à une température approximativement de 650°C.

5. Une méthode selon la revendication 2, selon laquelle ladite couche épitaxiale est du $Al_{0,30}Ga_{0,70}As$ et ledit substrat est orienté en s'écartant dudit axe ⟨100⟩ d'au moins 3° et ledit substrat est maintenu à une température approximativement de 620°C.

6

EP 0 197 452 B1

**Patentansprüche**

1. Verfahren, das Wachstum einer epitaxialen Schicht aus einem monokristallinen Material mit einer praktisch glatten Oberfläche hervorzurufen,

bei dem eine Unterlage aus monokristallinem Galliumarsenid vorgesehen wird, deren Wachstumsfläche zwischen 2,75° und 10° aus der Achse ⟨100⟩ der Unterlage heraus in Richtung auf die Achse ⟨111⟩ des Galliums orientiert ist, und

bei dem die Unterlage den Bedingungen eines epitaxialen Wachstums durch einen Molekülstrahl ausgesetzt wird, welche normalerweise an einer nominellen ⟨100⟩-Unterlage ein Wachstum mit einer rauhen Oberfläche hervorrufen würden.

2. Verfahren gemäß Anspruch 1, bei dem zu dem Schritt, die Unterlage auszusetzen, ferner die Schritte gehören:

die Unterlage auf eine Temperatur zwischen 600° C und 700° C zu bringen und

die Unterlage einer Molekül-Strahlströmung aus Aluminium Al, Gallium Ga und Arsen As auszusetzen.

3. Verfahren gemäß Anspruch 2, bei dem die epitaxiale Schicht aus der Verbindung $Al_{0,15}Ga_{0,85}As$ besteht und die Unterlage um mindestens 2,75° aus der ⟨100⟩-Achse heraus orientiert und auf einer Temperatur von annähernd 675° C gehalten wird.

4. Verfahren gemäß Anspruch 2, bei dem die epitaxiale Schicht aus der Verbindung $Al_{0,30}Ga_{0,70}As$ besteht und die Unterlage um mindestens 5° aus der ⟨100⟩-Achse heraus orientiert und auf einer Temperatur von annähernd 650° C gehalten wird.

5. Verfahren gemäß Anspruch 2, bei dem die epitaxiale Schicht aus der Verbindung $Al_{0,03}Ga_{0,70}As$ besteht und die Unterlage um mindestens 3° aus der ⟨100⟩-Achse heraus orientiert und auf einer Temperatur von annähernd 620° C gehalten wird.

7

FIG. 1A

FIG. 1B

FIG. 1C

EP 0 197 452 B1

FIG. 1D

FIG.3A

10⌐

12⌐

FIG.3B

9

FIG.2

## *FIG. 4A*

## *FIG. 4B*